Europäisches Patentamt

European Patent Office

Office européen des brevets

(19)

(11)  **EP 1 316 147 B1**

(12)  ## EUROPÄISCHE PATENTSCHRIFT

(45) Veröffentlichungstag und Bekanntmachung des Hinweises auf die Patenterteilung:
**07.04.2004  Patentblatt 2004/15**

(51) Int Cl.7: **H03H 17/06**

(21) Anmeldenummer: **01974013.3**

(86) Internationale Anmeldenummer:
**PCT/DE2001/003403**

(22) Anmeldetag: **05.09.2001**

(87) Internationale Veröffentlichungsnummer:
**WO 2002/021688 (14.03.2002 Gazette 2002/11)**

(54) **VERFAHREN UND VORRICHTUNG ZUM KONVERTIEREN EINER ABTASTFREQUENZ IN MULTISTANDARD-SYSTEME**

METHOD AND DEVICE FOR CONVERTING A SCANNING FREQUENCY IN MULTISTANDARD SYSTEMS

PROCEDE ET DISPOSITIF POUR CONVERTIR UNE FREQUENCE D'ECHANTILLONNAGE EN SYSTEMES MULTISTANDARDS

(84) Benannte Vertragsstaaten:
**DE FR GB**

(30) Priorität: **07.09.2000  DE 10044258**

(43) Veröffentlichungstag der Anmeldung:
**04.06.2003  Patentblatt 2003/23**

(73) Patentinhaber: **Siemens Aktiengesellschaft 80333 München (DE)**

(72) Erfinder:
- **GÖCKLER, Heinz**
  **71522 Backnang (DE)**
- **WESSELING, Matthias**
  **46286 Dorsten (DE)**
- **EHLERT, Andre**
  **46414 Rhede (DE)**

(56) Entgegenhaltungen:

| | |
|---|---|
| WO-A-00/51376 | WO-A-98/21819 |
| DE-A- 19 548 614 | US-A- 5 323 391 |
| US-A- 5 570 137 | |

- **MING JIAN ET AL: "An efficient IF architecture for dual-mode GSM/W-CDMA receiver of a software radio" MOBILE MULTIMEDIA COMMUNICATIONS, 1999. (MOMUC '99). 1999 IEEE INTERNATIONAL WORKSHOP ON SAN DIEGO, CA, USA 15-17 NOV. 1999, PISCATAWAY, NJ, USA,IEEE, US, 15. November 1999 (1999-11-15), Seiten 21-24, XP010370694 ISBN: 0-7803-5904-6**
- **CHESTER D B: "A generalized rate change filter architecture" STATISTICAL SIGNAL AND ARRAY PROCESSING. MINNEAPOLIS, APR. 27 - 30, 1993, PROCEEDINGS OF THE INTERNATIONAL CONFERENCE ON ACOUSTICS, SPEECH, AND SIGNAL PROCESSING (ICASSP), NEW YORK, IEEE, US, Bd. 4, 27. April 1993 (1993-04-27), Seiten 181-184, XP010110571 ISBN: 0-7803-0946-4**

EP 1 316 147 B1

**Beschreibung**

Die Erfindung bezieht sich auf ein Verfahren und eine Vorrichtung zum Konvertieren einer Abtastfrequenz nach dem Oberbegriff des Anspruchs 1 bzw. des Anspruchs 16.

Ein solches Verfahren bzw. eines solche Vorrichtung ist aus der US-A-5,570,137 bekannt, und zwar im Zusammenhang mit der Verarbeitung analoger Fernsehsignale.

Beispielsweise bei der Übertragung eines digitalen Signals über verschiedene Medien ist es häufig erforderlich, die Sampling- beziehungsweise Abtastrate des digitalen Signals auf andere Abtastraten zu konvertieren. Insbesondere wenn diese Abtastraten variabel gehalten werden sollen, ist zur Konvertierung der Abtastfrequenz ein erheblicher Rechenaufwand erforderlich und/oder es müssen Qualitätsverluste in Kauf genommen werden.

Weiterhin existiert eine Vielzahl von Mobilfunk-Standards die unterschiedliche Abtastfrequenzen beziehungsweise Symbolraten voraussetzen. Die Begriffe Abtastfrequenz und Symbolrate werden in diesem Zusammenhang nachfolgend gleichwertig verwendet.

Beispiele für derartige Mobilfunk-Standards sind der GSM-Standard (Global System For Mobile Communications), der AMPS-Standard (Advanced Mobile Phone Service), der CDMA-Standard (Code-Division Multiple Access), der iDEN-Standard (integrated Digital Enhanced Network), der TDMA-Standard (Time Division Multiple Access) oder der UMTS-Standard (Universal Mobile Telecommunications System). Insbesondere im Zusammenhang mit der schnurlosen Telefonie ist weiterhin der DECT-Standard (Digital European Cordless Telecommunications) bekannt, bei dem es sich technisch gesehen um ein picozellulares, hierarchisch gruppiertes System handelt, das mit einer sehr effizienten dynamischen Kanalselektion arbeitet.

Der genannte UMTS-Standard soll ab dem Jahr 2002 kommerziell eingesetzt werden, und es ist davon auszugehen, dass der UMTS-Standard den derzeit in Europa überwiegend eingesetzten GSM-Standard mittelfristig ablösen wird. Der UMTS-Standard sieht höhere Kapazitäten und Bandbreiten als der GSM-Standard vor und soll darüber hinaus ein breites Spektrum von Sprach-, Video- und sowohl leitungs- als auch paketvermittelten Datendiensten für Multimedia-Anwendungen und Internet-basierte Dienste über die Funkschnittstelle erlauben. Bei dieser Funkschnittstelle handelt es sich um eine universelle Funkschnittstelle, wobei eine einheitliche Luftschnittstelle (UMTS Terrestrial Radio Access, UTRA) für die schnurlose Telefonie, Satellitenfunk, den Mobilfunk und den drahtlosen Ortsanschluss über den DECT-Standard die Konvergenz der Netze fördern soll. Innerhalb der Netze soll der Dual-Mode/Dual-Band-Betrieb von GSM und UMTS sowie das Roaming zwischen GSMund UMTS-Netzen unterschiedlicher Betreiber gewährleistet sein.

Wie erwähnt sehen verschiedene Standards unterschiedliche Abtastfrequenzen beziehungsweise Symbolraten vor. Beim GSM-Standard beträgt die Symbolrate beispielsweise 270,83 kHz, während sie beim DECT-Standard 1152 kHz und beim UMTS-Standard 4096 kHz beträgt.

Der vorliegenden Erfindung liegt die **Aufgabe** zugrunde, die Abtastfrequenz eines digitalen Signals, insbesondere eines digitalen Signals, das durch Analog-/Digitalwandlung eines empfangenen Mobilfunksignals erhalten wurde, mit geringem Aufwand auf die jeweils erforderliche Abtastfrequenz beziehungsweise Symbolrate zu konvertieren.

Diese Aufgabe wird durch die in den unabhängigen Ansprüchen genannten Merkmale gelöst.

Vorteilhafte Ausgestaltungen und Weiterbildungen der Erfindung ergeben sich aus den Unteransprüchen.

Bei dem erfindungsgemäßen Verfahren zum Konvertieren einer ersten Abtastfrequenz eines digitalen Signals in eine oder mehrere weitere Abtastfrequenzen ist vorgesehen, dass die jeweilige Konvertierung in zumindest zwei Teilkonvertierungsschritte aufgeteilt wird, von denen jeder das Heraufsetzen oder das Herabsetzen der Abtastfrequenz um einen Faktor umfasst. Jeder einzelne Teilkonvertierungsschritt wird dabei so gewählt, dass der Aufwand klein ist, wobei durch das schrittweise Herauf- und Herabsetzen der Abtastrate der erforderliche Rechenaufwand zum Teil bei niedrigen Abtastraten entsteht, so dass der Gesamtaufwand insgesamt niedrig wird.

Insbesondere im Zusammenhang mit dem Mobilfunk kann vorgesehen sein, dass das digitale Signal durch eine mit der ersten Abtastfrequenz durchgeführte Analog-/Digitalwandlung eines Analogsignals erzeugt wird, dass das Analogsignal einen Bitstrom mit einer Bitrate darstellt, und dass zumindest eine der weiteren Abtastfrequenzen ein ganzzahliges Vielfaches der Bitrate ist. Im Zusammenhang mit dem Mobilfunk ist unter dieser Bitrate die Bitrate des zu sendenden digitalen Signals zu verstehen, das zur Erzeugung des Analogsignals digital-/analog gewandelt wird.

Zur Erfüllung des Abtasttheorems muss die erste Abtastfrequenz größer als die weiteren Abtastfrequenzen sein. Gemäß dem Abtasttheorem muss die Abtastfrequenz höher als das Doppelte der höchsten im Signal enthaltenen Frequenz sein.

Obwohl die vorliegende Erfindung auch auf andere Bereiche der Technik anwendbar ist, kann das Analogsignal insbesondere ein empfangenes Mobilfunksignal sein.

In diesem Zusammenhang ist es denkbar, dass das Analogsignal ein empfangenes Mobilfunksignal ist, das dem UMTS-, DECT- oder GSM-Standard entspricht. Selbstverständlich sind auch andere Standards denkbar, beispielsweise die eingangs erwähnten, insbesondere auch der AMPS-Standard.

Das erfindungsgemäße Verfahren sieht vorzugsweise vor, dass jeder Faktor, um den die Abtastfrequenz bei jedem Teilkonvertierungsschritt heraufgesetzt oder herabgesetzt wird, ein ganzzahliger Faktor ist. Durch die Verwendung eines ganzzahligen Faktors kann der für einen Teilkonvertierungsschritt erforderliche Rechenaufwand besonders klein gehalten werden.

Das erfindungsgemäße Verfahren kann weiterhin vorsehen, dass der Wert des Quotienten aus dem Produkt der Faktoren, um die die Abtastfrequenz heraufgesetzt wird, und dem Produkt der Faktoren, um die die Abtastfrequenz herabgesetzt wird, für jede weitere Abtastfrequenz dem Wert des Quotienten aus der weiteren Abtastfrequenz und der ersten Abtastfrequenz entspricht.

Zur Bestimmung der jeweiligen Faktoren sieht das erfindungsgemäße Verfahren vorzugsweise vor, dass die Bestimmung der ganzzahligen Faktoren für jede weitere Abtastfrequenz die Faktorisierung des Zählers und/oder des Nenners eines Bruches umfasst, der den Wert des Quotienten aus der weiteren Abtastfrequenz und der ersten Abtastfrequenz hat. Als Faktorisierungsverfahren kommen beispielsweise die Methode der Probedivision, die Fermat-Methode, die (p-1)-Methode, die Pollard-Rho-Methode oder die Methode des quadratischen Siebes in Frage, wobei hinsichtlich dieser Methoden auf die einschlägige Fachliteratur verwiesen wird.

Um den Rechenaufwand so gering wie möglich zu halten sieht das erfindungsgemäße Verfahren vorzugsweise vor, dass der Bruch ein gekürzter Bruch aus natürlichen Zahlen ist. Damit der Bruch mit der weiteren Abtastfrequenz als Zähler und der ersten Abtastfrequenz als Nenner natürliche Zahlen aufweist, muss dieser Bruch gegebenenfalls entsprechend den unter Umständen vorhandenen Nachkommastellen der Abtastfrequenzen erweitert werden.

Im Zusammenhang mit dem Mobilfunk sieht das erfindungsgemäße Verfahren vorzugsweise vor, dass eine oder mehrere der weiteren Abtastfrequenzen einer bei einem Mobilfunk-Standard vorgesehenen Abtastfrequenz beziehungsweise Symbolrate oder einem ganzzahligen Vielfachen davon entspricht.

In diesem Zusammenhang ist es beispielsweise denkbar, dass eine Abtastfrequenz der weiteren Abtastfrequenzen die beim UMTS-Standard vorgesehene Abtastfrequenz beziehungsweise Symbolrate oder ein ganzzahliges Vielfaches davon ist, und/oder dass eine Abtastfrequenz der weiteren Abtastfrequenzen die beim DECT-Standard vorgesehene Abtastfrequenz beziehungsweise Symbolrate ist oder ein ganzzahliges Vielfaches davon, und/oder dass eine Abtastfrequenz der weiteren Abtastfrequenzen die beim GSM-Standard vorgesehene Abtastfrequenz beziehungsweise Symbolrate oder ein ganzzahliges Vielfaches davon ist. Selbstverständlich können auch Abtastfrequenzen anderer Standards verwendet werden.

Bei einer bevorzugten Ausführungsform des erfindungsgemäßen Verfahrens beträgt die erste Abtastfrequenz 16384 kHz. Die erste Abtastfrequenz kann weiterhin die Abtastfrequenz eines Analog-/Digitalwandlers sein. Das Ausgangssignal dieses Analog-/Digitalwandlers kann dann zur Erzeugung unterschiedlicher weiter Abtastfrequenzen verwendet werden, so dass insgesamt nur eine Referenzfrequenz zur Verfügung gestellt werden muss.

Wenn die erste Abtastfrequenz 16384 kHz beträgt, kann diese um die Faktoren 2 und 2 herabgesetzt werden, um als Abtastfrequenz die Symbolrate des UMTS-Standards zu erzeugen.

Weiterhin kann diese erste Abtastfrequenz von 16384 kHz um die Faktoren 2, 8 und 8 herabgesetzt und um die Faktoren 3 und 3 heraufgesetzt werden, um als Abtastfrequenz die Symbolrate des DECT-Standards zu erzeugen.

Schließlich kann diese erste Abtastfrequenz 16384 kHz um die Faktoren 2, 8, 12, 8, 8 und 8 herabgesetzt und um die Faktoren 13, 5, 5 und 5 heraufgesetzt werden, um als Abtastfrequenz die Symbolrate des GSM-Standards zu erzeugen.

Insbesondere wenn das digitale Signal in mehrere unterschiedliche weitere Abtastfrequenzen umgesetzt wird, beispielsweise entsprechend den unterschiedlichen Symbolraten von Mobilfunkstandards, kann zumindest ein Ergebnis eines Teilkonvertierungsschrittes zur Erzeugung von zumindest zwei unterschiedlichen weiteren Abtastfrequenzen verwendet wird, sofern die jeweiligen Faktoren dies ermöglichen. Auf diese Weise lässt sich der erforderliche Schaltungsaufwand verringern. Es ist daher Vorteilhaft, wenn die Anzahl der insgesamt durchgeführten Teilkonvertierungsschritte minimiert wird.

Bei der erfindungsgemäßen Vorrichtung zum Konvertieren einer ersten Abtastfrequenz eines digitalen Signals in eine oder mehrere weitere Abtastfrequenzen beziehungsweise Symbolraten sieht die Vorrichtung Mittel zum Durchführen von zumindest zwei Teilkonvertierungsschritten pro weiterer Abtastfrequenz vor, wobei jeder Teilkonvertierungsschritt das Heraufsetzen oder das Herabsetzen der Abtastfrequenz um einen Faktor umfasst. Durch die Aufteilung der Konvertierung in zumindest zwei Teilkonvertierungsschritte kann der schaltungstechnische Aufwand vergleichsweise klein gehalten werden, da durch das schrittweise Heraufsetzen oder Herabsetzen der Abtastfrequenz der Rechenaufwand zum Teil bei niedrigen Abtastraten entsteht.

Die Mittel können beispielsweise durch geeignete Polyphasenfilter gebildet sein. Derartige Polyphasenfilter sind dazu in der Lage, zwei Teilkonvertierungsschritte parallel durchzuführen, so dass beispielweise ein Herabsetzen der Abtastfrequenz um 3/8 möglich ist.

Das digitale Signal, dessen Abtastfrequenz durch die erfindungsgemäße Vorrichtung konvertiert wird, wird vorzugsweise durch eine mit der ersten Abtastfrequenz durchgeführte Analog-/Digitalwandlung eines Analogsignals erzeugt, wobei dieses Analogsignal einen Bitstrom mit einer Bitrate darstellen kann und zumindest eine der weiteren Abtastfrequenzen ein ganzzahliges Vielfaches dieser Bitrate ist.

Damit das Abtasttheorem für alle weiteren Abtastfrequenzen erfüllt wird, ist auch bei der erfindungsgemäßen Vorrichtung vorzugsweise vorgesehen, dass die erste Abtastfrequenz entsprechend dem Abtasttheorem größer als die weiteren Abtastfrequenzen ist.

Auch bei der erfindungsgemäßen Vorrichtung kann vorgesehen sein, dass das Analogsignal ein empfangenes Mobilfunksignal ist, beispielsweise ein Mobilfunksignal, das dem UMTS-, DECToder GSM-Standard entspricht.

Der Rechenaufwand und damit auch der schaltungstechnisch erforderliche Aufwand kann bei der erfindungsgemäßen Vorrichtung besonders klein gehalten werden, wenn jeder Faktor, um den die Abtastfrequenz bei einem Teilkonvertierungsschritt heraufgesetzt oder herabgesetzt wird, ein ganzzahliger Faktor ist.

Damit die erfindungsgemäße Vorrichtung die gewünschten weiteren Abtastfrequenzen genau erzeugen kann, entspricht der Wert des Quotienten aus dem Produkt der Faktoren, um die die Abtastfrequenz heraufgesetzt wird, und dem Produkt der Faktoren, um die die Abtastfrequenz herabgesetzt wird, für jede weitere Abtastfrequenz dem Wert des Quotienten aus der weiteren Abtastfrequenz und der ersten Abtastfrequenz.

Obwohl die jeweils verwendeten Faktoren der erfindungsgemäßen Vorrichtung auch in geeigneter Weise von außen zugeführt werden können, kann es in einigen Fällen erforderlich sein, dass diese Faktoren durch die erfindungsgemäße Vorrichtung selbst bestimmt werden. Diese Bestimmung der vorzugsweise ganzzahligen Faktoren kann dann für jede weitere Abtastfrequenz die Faktorisierung des Zählers und/oder des Nenners eines Bruches umfassen, der den Wert des Quotienten aus der entsprechenden weiteren Abtastfrequenz und der ersten Abtastfrequenz hat. Als Faktorisierungsverfahren wird in diesem Fall vorzugsweise ein Verfahren gewählt, das sich sowohl hard- als auch softwaremäßig einfach implementieren lässt.

Um den Rechenaufwand bei der Durchführung der Faktorisierung so gering wie möglich zu halten, ist der Bruch vorzugsweise derart aufbereitet, dass es sich um einen gekürzten Bruch aus natürlichen Zahlen handelt.

Eine oder mehrere der weiteren Abtastfrequenzen können einer bei einem Mobilfunk-Standard vorgesehenen Abtastfrequenz oder einem ganzzahligen Vielfachen davon entsprechen, beispielsweise einer Symbolrate der eingangs genannten Mobilfunk-Standards.

Insbesondere hinsichtlich der bevorstehenden Einführungsphase des UMTS-Standards kann vorgesehen sein, dass eine Abtastfrequenz der weiteren Abtastfrequenzen die beim UMTS-Standard vorgesehene Abtastfrequenz beziehungsweise Symbolrate oder ein ganzzahliges Vielfaches davon ist, und/oder dass eine Abtastfrequenz der weiteren Abtastfrequenzen die beim DECT-Standard vorgesehene Abtastfrequenz beziehungsweise Symbolrate oder ein ganzzahliges Vielfaches davon ist, und/oder dass eine Abtastfrequenz der weiteren Abtastfrequenzen, die beim GSM-Standard vorgesehene Abtastfrequenz beziehungsweise Symbolrate oder ein ganzzahliges Vielfaches davon ist. Durch eine derartige Wahl der weiteren Abtastfrequenzen könnte beispielsweise eine Vorrichtung geschaffen werden, die alle empfangenen Analogsignale der genannten Mobilfunk-Standards verarbeiten kann.

Zu diesem Zweck kann die erste Abtastfrequenz beispielsweise 16384 kHz betragen. Die erste Abtastfrequenz kann weiterhin die feste Abtastfrequenz eines Analog-/Digitalwandlers sein.

Obwohl die Vorrichtung dazu in der Lage ist, verschiedenen weitere Abtastfrequenzen zu erzeugen, muss in diesem Fall nur eine Referenzfrequenz vorgesehen werden, was zur Verringerung des erforderlichen Schaltungsaufwandes beiträgt.

Wenn die erste Abtastfrequenz 16384 kHz beträgt, kann die erfindungsgemäße Vorrichtung diese beispielsweise um die Faktoren 2 und 2 herabsetzen, um als Abtastfrequenz die Symbolrate des UMTS-Standards zu erzeugen.

Zur Erzeugung der Abtastfrequenz beziehungsweise der Symbolrate des DECT-Standards müsste die erfindungsgemäße Vorrichtung die genannte erste Abtastfrequenz von 16384 kHz beispielsweise um die Faktoren 2, 8 und 8 herabsetzen und um die Faktoren 3 und 3 heraufsetzen.

Die Abtastfrequenz beziehungsweise die Symbolrate des GSM-Standards könnte bei dieser ersten Abtastfrequenz von 16384 kHz dadurch erzeugt werden, dass diese um die Faktoren 2, 8, 12, 8, 8 und 8 herabgesetzt und um die Faktoren 13, 5, 5 und 5 heraufgesetzt wird.

Obwohl je nach Wahl der weiteren Abtastfrequenzen auch andere Ausführungsformen denkbar sind, kann die erfindungsgemäße Vorrichtung ein Mobilfunkterminal beziehungsweise ein Mobilfunkendgerät sein.

Insbesondere wenn das digitale Signal in mehrere unterschiedliche weitere Abtastfrequenzen umgesetzt wird, ist es vorteilhaft, dass die Vorrichtung derart ausgelegt ist, dass zumindest ein Ergebnis eines Teilkonvertierungsschrittes zur Erzeugung von zumindest zwei unterschiedlichen weiteren Abtastfrequenzen verwendet wird, soweit die jeweiligen Faktoren dies ermöglichen. Auf diese Weise lässt sich der erforderliche Schaltungsaufwand verringern. Es ist daher besonders Vorteilhaft, wenn die Anzahl der insgesamt durchgeführten Teilkonvertierungsschritte minimiert wird.

Ein Ausführungsbeispiel der vorliegenden Erfindung wird nachfolgend anhand der zugehörigen Zeichnung näher erläutert.

Es zeigt:

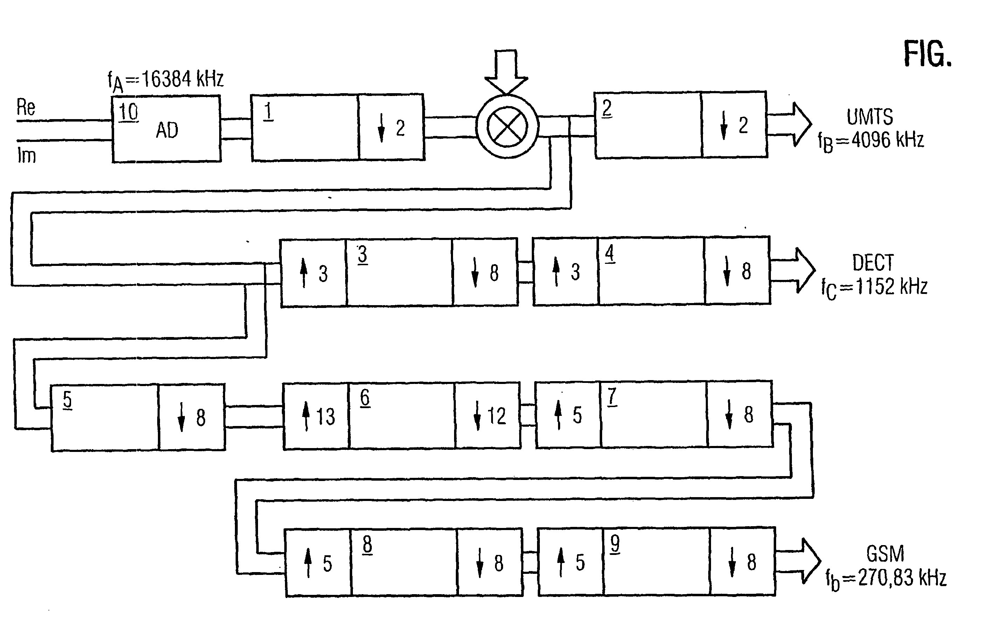

Figur 1 ein Blockschaltbild einer Ausführungsform der erfindungsgemäßen Vorrichtung, mit der das erfindungsgemäße Verfahren durchgeführt werden kann.

Gemäß dem in Figur 1 dargestellten Blockschaltbild ist der Ausgang eines Analog-/Digitalwandlers 10 mit dem Eingang eines ersten Polyphasenfilters 1 verbunden, dessen Ausgang mit einem zweiten Polyphasenfilter 2 in Verbindung steht. Der Ausgang des ersten Polyphasenfilters 1 ist weiterhin mit dem Eingang eines dritten Polyphasenfilters 3 verbunden, dessen Ausgang mit dem Eingang eines vierten Polyphasenfilters 4 in Verbindung steht. Der Ausgang des ersten Polyphasenfilters 1 ist weiterhin mit dem Eigang eines fünften Polyphasenfilters 5 verbunden, dessen Ausgang mit dem Eingang eines sechsten Polyphasenfilters 6 in Verbindung steht. Der Ausgang des sechsten Polyphasenfilters 6 steht mit dem Eingang eines siebten Polyphasenfilters 7 in Verbindung, dessen Ausgang wiederum mit dem Eingang eines achten Polyphasenfilters 8 in Verbindung steht. Der Ausgang dieses achten Polyphasenfilters 8 steht mit dem Eingang eines neunten Polyphasenfilters 9 in Verbindung.

Die Funktionsweise der in Figur 1 als Blockschaltbild dargestellten erfindungsgemäßen Vorrichtung ist wie folgt. Dem A-nalog-/Digitalwandler 10 wird ein analoges Signal zugeführt, das zur Analog-/Digitalwandlung mit der ersten Abtastfrequenz $f_A$ abgetastet wird, die im dargestellten Fall 16384 kHz beträgt.

Das mit dem Ausgang des Analog-/Digitalwandlers 10 verbundene erste Polyphasenfilter 1 setzt die erste Abtastfrequenz $f_A$ um den Faktor 2 herab, so dass die Abtastfrequenz am Ausgang des ersten Polyphasenfilters 8192 kHz beträgt. Das dem ersten Polyphasenfilter 1 nachgeschaltete zweite Polyphasenfilter 2 setzt die Abtastfrequenz ein weiteres Mal um den Faktor 2 herab, so dass dem zweiten Polyphasenfilter 2 ein Signal entnommen werden kann, dessen Abtastfrequenz $f_B$ 4096 kHz beträgt, was der beim UMTS-Standard vorgesehenen Symbolrate entspricht.

Um ein Signal mit der beim DECT-Standard vorgesehenen Abtastfrequenz mit $f_C$ = 1152 kHz zu erzeugen, setzt das dritte Polyphasenfilter 3 die durch das erste Polyphasenfilter 1 erzeugte Abtastfrequenz von 8192 kHz zunächst um den Faktor 3 herauf und dann um den Faktor 8 herab, so dass die Abtastfrequenz nach dem dritten Polyphasenfilter 3 3072 kHz beträgt. Diese Abtastfrequenz wird von dem vierten Polyphasenfilter 4 zunächst um 3 herauf- und dann um 8 herabgesetzt, so dass die Abtastfrequenz $f_C$ am Ausgang des vierten Polyphasenfilters 4 1152 kHz beträgt, was der Symbolrate des DECT-Standards entspricht.

Das dem ersten Polyphasenfilter 1 entnommene Signal mit der Abtastfrequenz von 8192 kHz wird weiterhin einem fünften Polyphasenfilter 5 zugeführt, das die Abtastfrequenz um den Faktor 8 herabsetzt, wodurch sich eine Abtastfrequenz von 1024 kHz ergibt. Anschließend setzt das sechste Polyphasenfilter 6 diese Abtastfrequenz zunächst um den Faktor 13 herauf und dann um den Faktor 12 herab, wodurch eine Abtastfrequenz von 1109,$\bar{3}$ erhalten wird. Diese Abtastfrequenz von 1109,$\bar{3}$ wird durch das siebte Polyphasenfilter 7 zunächst um den Faktor 5 heraufgesetzt und dann um Faktor 8 herabgesetzt, so dass sich eine Abtastfrequenz von 693,3 ergibt. Das achte Polyphasenfilter 8 setzt diese Abtastfrequenz um den Faktor 5 herauf und dann um den Faktor 8 herab, wodurch eine Abtastfrequenz von 433,$\bar{3}$ erhalten wird, die von dem neunten Polyphasenfilter 9 um den Faktor 5 herauf- und dann um den Faktor 8 herabgesetzt wird, um die Abtastfrequenz $f_D$ = 270,83 kHz zu erzeugen, die der Symbolrate des GSM-Standards entspricht.

Hinsichtlich der bei der Ausführungsform gemäß Figur 1 eingesetzten Faktoren ist festzustellen, dass der Quotient aus der weiteren Abtastfrequenz $f_B$ = 4096 kHz und der ersten Abtastfrequenz $f_A$ = 16384 kHz dem Wert des Quotienten aus 1 und dem Produkt der Faktoren 2 und 2 entspricht.

In ähnlicher Weise entspricht der Wert des Quotienten aus der weiteren Abtastfrequenz $f_C$ = 1152 kHz und der ersten Abtastfrequenz $f_A$ = 16384 kHz dem Wert des Quotienten aus dem Produkt der Faktoren 3 und 3 und dem Produkt der Faktoren 2, 2, 8 und 8.

Hinsichtlich der beim GSM-Standard verwendeten Abtastfrequenz von $f_D$ = 270,83 kHz ist festzustellen, dass der Wert des Quotienten aus der weiteren Abtastfrequenz $f_D$ = 270,83 kHz und der ersten Abtastfrequenz $f_A$ = 16384 kHz dem Wert des Quotienten aus dem Produkt der Faktoren 13, 5, 5 und 5 und dem Produkt der Faktoren 2, 8, 12, 8, 8 und 8 entspricht.

Der erforderliche Schaltungsaufwand wird bei der dargestellten Ausführungsform auch dadurch verringert, dass das am Ausgang des ersten Polyphasenfilters 1 anliegende Ergebnis zur Erzeugung der Symbolrate des UMTS-Standards, zur Erzeugung der Symbolrate des DECT-Standards und zur Erzeugung der Symbolrate des GSM-Standards verwendet wird. Dadurch sind zwei Polyphasenfilter weniger erforderlich, als in einem Fall, in dem jeder Standard unabhängig von den anderen Standards erzeugt wird. In Abhängigkeit von den zu erzeugenden weiteren Abtastfrequenzen und der Wahl der Faktoren sind darüber hinaus Ausführungsformen denkbar, bei denen sich eine entsprechende Minimierung der erforderlichen Polyphasenfilter noch deutlicher Auswirkt.

Durch die vorliegende Erfindung wird das Problem des Umwandelns eines analogen Signals auf ein digitales Signal mit exakter Abtastfrequenz von einer die Erzeugung einer entsprechenden Referenzfrequenz umfassenden analogen Lösung zu einer digitalen Lösung verschoben. Bei dieser digitalen Lösung erfolgt die Abtastung des Analogsignals mit einer konstanten ersten Abtastfrequenz und das Umtasten des digitalen Signals auf andere Abtastfrequenzen wird in einfacher Weise ermöglicht.

Wenn ein analoges Signal in Digitalsignale mit unterschiedlichen Abtastraten umgewandelt werden soll, ist es daher möglich nur einen Analog-/Digitalwandler vorzusehen, der mit einer festen ersten Abtastfrequenz betrieben werden kann. Die Bereitstellung von nur einer Referenzfrequenz ist daher in vielen Fällen ausreichend, wodurch der erforderliche Schaltungsaufwand verringert wird.

Die in der vorstehenden Beschreibung, in der Zeichnung sowie in den Ansprüchen offenbarten Merkmale der Erfindung können sowohl einzeln als auch in beliebiger Kombination für die Verwirklichung der Erfindung wesentlich sein.

**Patentansprüche**

1. Verfahren zum Konvertieren einer ersten Abtastfrequenz ($f_A$) eines digitalen Signals, das durch einen mit der ersten Abtastfrequenz ($f_A$) durchgeführte Analog-/Digitalwandlung eines analogen Signals erzeugt wird, in mehrere weitere Abtastfrequenzen ($f_B$, $f_C$, $f_D$), bei dem die jeweilige Konvertierung in zumindest zwei Teilkonvertierungsschritte aufgeteilt wird, von denen jeder das Heraufsetzen oder das Herabsetzen der Abtastfrequenz um einen Faktor umfasst, wobei zumindest ein Ergebnis eines Teilkonvertierungsschrittes zur Erzeugung von zumindest zwei unterschiedlichen weiteren Abtastfrequenzen ($f_B$, $f_C$, $f_D$) verwendet wird, **dadurch gekennzeichnet,** **dass** das Analogsignal einen Bitstrom eines Mobilfunksignals mit einer Bitrate darstellt und zumindest eine der weiteren Abtastfrequenzen ($f_B$, $f_C$, $f_D$) ein ganzzahliges vielfaches der Bitrate ist.

2. Verfahren nach einem der vorhergehenden Ansprüche, **dadurch gekennzeichnet,** **dass** die erste Abtastfrequenz ($f_A$) größer als die weiteren Abtastfrequenzen ($f_B$, $f_C$, $f_D$) ist.

3. , Verfahren nach einem der vorhergehenden Ansprüche, **dadurch gekennzeichnet,** **dass** das Analogsignal ein empfangenes Mobilfunksignal ist.

4. Verfahren nach einem der vorhergehenden Ansprüche, **dadurch gekennzeichnet,** **dass** das Analogsignal ein empfangenes Mobilfunksignal ist, das dem UMTS-, DECT- oder GSM-Standard entspricht.

5. Verfahren nach einem der vorhergehenden Ansprüche, **dadurch gekennzeichnet,**

**dass** jeder Faktor ein ganzzahliger Faktor ist.

6. Verfahren nach einem der vorhergehenden Ansprüche, **dadurch gekennzeichnet,** **dass** der Wert des Quotienten aus dem Produkt der Faktoren, um die die Abtastfrequenz heraufgesetzt wird, und dem Produkt der Faktoren, um die die Abtastfrequenz herabgesetzt wird, für jede weitere Abtastfrequenz ($f_B$, $f_C$, $f_D$) dem Wert des Quotienten aus der weiteren Abtastfrequenz ($f_B$, $f_C$, $f_D$) und der ersten Abtastfrequenz ($f_A$) entspricht.

7. Verfahren nach einem der vorhergehenden Ansprüche, **dadurch gekennzeichnet,** **dass** die Bestimmung der ganzzahligen Faktoren für jede weitere Abtastfrequenz ($f_B$, $f_C$, $f_D$) die Faktorisierung des Zählers und/oder des Nenners eines Bruches umfasst, der den Wert des Quotienten aus der weiteren Abtastfrequenz ($f_B$, $f_C$, $f_D$) und der ersten Abtastfrequenz ($f_A$) hat.

8. Verfahren nach einem der vorhergehenden Ansprüche, **dadurch gekennzeichnet,** **dass** der Bruch ein gekürzter Bruch aus natürlichen zahlen ist.

9. Verfahren nach einem der vorhergehenden Ansprüche, **dadurch gekennzeichnet,** **dass** eine oder mehrere der weiteren Abtastfrequenzen ($f_B$, $f_C$, $f_D$) einer bei einem Mobilfunk-Standard vorgesehenen Abtastfrequenz oder einem ganzzahligen Vielfachen davon entsprechen.

10. Verfahren nach einem der vorhergehenden Ansprüche. **dadurch gekennzeichnet,** **dass** eine Abtastfrequenz ($f_B$) der weiteren Abtastfrequenzen ($f_B$, $f_C$, $f_D$) die beim UMTS-Standard vorgesehene Abtastfrequenz oder ein ganzzahliges Vielfaches davon ist, und/oder dass eine Abtastfrequenz ($f_C$) der weiteren Abtastfrequenzen ($f_B$, $f_C$, $f_D$) die beim DECT-Standard vorgesehene Abtastfrequenz oder ein ganzzahliges Vielfaches davon ist, und/oder dass eine Abtastfrequenz ($f_D$) der weiteren Abtastfrequenzen ($f_B$, $f_C$, $f_D$) die beim GSM-Standard vorgesehene Abtastfrequenz oder ein ganzzahliges Vielfaches davon ist.

11. Verfahren nach einem der vorhergehenden Ansprüche, **dadurch gekennzeichnet,** **dass** die erste Abtastfrequenz ($f_A$) 16384 kHz beträgt und/oder dass die erste Abtastfrequenz ($f_A$) die Abtastfrequenz eines Analog-/Digitalwandlers ist.

**12.** Verfahren nach einem der vorhergehenden Ansprüche,
**dadurch gekennzeichnet,**
**dass** die erste Abtastfrequenz ($f_A$) um die Faktoren 2 und 2 herabgesetzt wird, um die Abtastfrequenz des UMTS-Standards zu erzeugen.

**13.** Verfahren nach einem der vorhergehenden Ansprüche,
**dadurch gekennzeichnet,**
**dass** die erste Abtastfrequenz ($f_A$) um die Faktoren 2, 8 und 8 herabgesetzt und um die Faktoren 3 und 3 heraufgesetzt wird, um die Abtastfrequenz des DECT-Standards zu erzeugen.

**14.** Verfahren nach einem der vorhergehenden Ansprüche,
**dadurch gekennzeichnet,**
**dass** die erste Abtastfrequenz ($f_A$) um die Faktoren 2, 8, 12, 8, 8 und 8 herabgesetzt und um die Faktoren 13, 5, 5 und 5 heraufgesetzt wird, um die Abtastfrequenz des GSM-Standards zu erzeugen.

**15.** Vorrichtung zum Konvertieren einer ersten Abtastfrequenz ($f_A$) eines digitalen Signals, das durch eine mit der ersten Abtastfrequenz ($f_A$) durchgeführte Analog-/Digitalwandlung eines von der Vorrichtung empfangenen Signals erzeugt wird, in mehrere weitere Abtastfrequenzen ($f_B$, $f_C$, $f_D$), wobei die Vorrichtung Mittel zum Durchführen von zumindest zwei Teilkonvertierungsschritten pro weiterer Abtastfrequenz ($f_B$, $f_C$, $f_D$) aufweist, wobei jeder Teilkonvertierungsschritt das Heraufsetzen oder das Herabsetzen der Abtastfrequenz um einen Faktor umfaßt und zumindest ein Ergebnis eines Teilkonvertierungsschrittes zur Erzeugung von zumindest zwei unterschiedlichen weiteren Abtastfrequenzen ($f_B$, $f_C$, $f_D$) verwendet wird.
**dadurch gekennzeichnet,**
**dass** das Analogsignal einen Bitstrom eines Mobilfunksignals mit einer Bitrate darstellt, und dass zumindest eine der weiteren Abtastfrequenzen (fB, fC, fD) ein ganzzahliges Vielfaches der Bitrate ist.

**16.** Vorrichtung nach Anspruch 15,
**dadurch gekennzeichnet,**
**dass** die Mittel durch einen oder mehrere geeignete Polyphasenfilter gebildet sind.

**17.** Vorrichtung nach einem der Ansprüche 15 bis 16,
**dadurch gekennzeichnet,**
**dass** die erste Abtastfrequenz ($f_A$) größer als die weiteren Abtastfrequenzen ($f_B$, $f_C$, $f_D$) ist.

**18.** Vorrichtung nach einem der Ansprüche 15 bis 17,
**dadurch gekennzeichnet,**

**dass** das Analogsignal ein empfangenes Mobilfunksignal ist, das dem UMTS-, DECT- oder GSM-Standard entspricht.

**19.** Vorrichtung nach einem der Ansprüche 15 bis 18,
**dadurch gekennzeichnet;**
**dass** jeder Faktor ein ganzzahliger Faktor ist.

**20.** Vorrichtung nach einem der Ansprüche 15 bis 19,
**dadurch gekennzeichnet,**
**dass** der Wert des Quotienten aus dem Produkt der Faktoren, um die die Abtastfrequenz heraufgesetzt wird, und dem Produkt der Faktoren, um die die Abtastfrequenz herabgesetzt wird, für jede weitere Abtastfrequenz ($f_B$, $f_C$, $f_D$) dem Wert des Quotienten aus der weiteren Abtastfrequenz ($f_B$, $f_C$, $f_D$) und der ersten Abtastfrequenz ($f_A$) entspricht.

**21.** Vorrichtung nach einem der Ansprüche 15 bis 20,
**dadurch gekennzeichnet,**
**dass** die Bestimmung der ganzzahligen Faktoren für jede weitere Abtastfrequenz ($f_B$, $f_C$, $f_D$) die Faktorisierung des Zählers und/oder des Nenners eines Bruches umfasst, der den Wert des Quotienten aus der weiteren Abtastfrequenz ($f_B$, $f_C$, $f_D$) und der ersten Abtastfrequenz ($f_A$) hat.

**22.** Vorrichtung nach einem der Ansprüche 15 bis 21,
**dadurch gekennzeichnet,**
**dass** der Bruch ein gekürzter Bruch aus natürlichen Zahlen ist.

**23.** Vorrichtung nach einem der Ansprüche 15 bis 22,
**dadurch gekennzeichnet,**
**dass** eine oder mehrere der weiteren Abtastfrequenzen ($f_B$, $f_C$, $f_D$) einer bei einem Mobilfunk-Standard vorgesehenen Abtastfrequenz oder einem ganzzahligen Vielfachen davon entsprechen.

**24.** Vorrichtung nach einem der Ansprüche 15 bis 23,
**dadurch gekennzeichnet,**
**dass** eine Abtastfrequenz ($f_B$) der weiteren Abtastfrequenzen ($f_B$, $f_C$, $f_D$) die beim UMTS-Standard vorgesehene Abtastfrequenz oder ein ganzzahliges Vielfaches davon ist, und/oder dass eine Abtastfrequenz ($f_C$) der weiteren Abtastfrequenzen ($f_B$, $f_C$, $f_D$) die beim DECT-Standard vorgesehene Abtastfrequenz oder ein ganzzahliges Vielfaches davon ist, und/oder dass eine Abtastfrequenz ($f_D$) der weiteren Abtastfrequenzen ($f_B$, $f_C$, $f_D$) die beim GSM-Standard vorgesehene Abtastfrequenz oder ein ganzzahliges Vielfaches davon ist.

**25.** Vorrichtung nach einem der Ansprüche 15 bis 24,
**dadurch gekennzeichnet,**
**dass** die erste Abtastfrequenz ($f_A$) 16384 kHz beträgt und/oder dass die erste Abtastfrequenz ($f_A$) die Abtastfrequenz eines Analog-/Digitalwandlers ist.

26. Vorrichtung nach einem der Ansprüche 15 bis 25, **dadurch gekennzeichnet,** **dass** die erste Abtastfrequenz ($f_A$) um die Faktoren 2 und 2 herabgesetzt wird, um die Abtastfrequenz des UMTS-Standards zu erzeugen.

27. Vorrichtung nach einem der Ansprüche 15 bis 26, **dadurch gekennzeichnet,** **dass** die erste Abtastfrequenz ($f_A$) um die Faktoren 2, 8 und 8 herabgesetzt und um die Faktoren 3 und 3 heraufgesetzt wird, um die Abtastfrequenz des DECT-Standards zu erzeugen.

28. Vorrichtung nach einem der Ansprüche 15 bis 27, **dadurch gekennzeichnet,** **dass** die erste Abtastfrequenz ($f_A$) um die Faktoren 2, 8, 12, 8, 8 und 8 herabgesetzt und um die Faktoren 13, 5, 5 und 5 heraufgesetzt wird, um die Abtastfrequenz des GSM-Standards zu erzeugen.

29. Vorrichtung nach einem der Ansprüche 15 bis 28, **dadurch gekennzeichnet,** **dass** sie ein Mobilfunkterminal ist.

**Claims**

1. Method for conversion of a first sampling frequency ($f_A$) of a digital signal, which is produced by analogue/digital conversion of an analogue signal carried out at the first sampling frequency ($f_A$), to two or more further sampling frequencies ($f_B$, $f_C$, $f_D$,), in which the respective conversion process is subdivided into at least two partial conversion steps, each of which comprises the stepping up or the stepping down of the sampling frequency by a factor, with at least one result of a partial conversion step being used for production of at least two different further sampling frequencies ($f_B$, $f_C$, $f_D$), **characterized** **in that** the analogue signal represents a bit stream of a mobile radio signal at a bit rate, and at least one of the further sampling frequencies ($f_B$, $f_C$, $f_D$) is an integer multiple of the bit rate.

2. Method according to one of the preceding claims, **characterized** **in that** the first sampling frequency ($f_A$) is greater than the further sampling frequencies ($f_B$, $f_C$, $f_D$).

3. Method according to one of the preceding claims, **characterized** **in that** the analogue signal is a received mobile radio signal.

4. Method according to one of the preceding claims, **characterized** **in that** the analogue signal is a received mobile radio signal which corresponds to the UMTS, DECT or GSM Standard.

5. Method according to one of the preceding claims, **characterized** **in that** each factor is an integer factor.

6. Method according to one of the preceding claims, **characterized** **in that** the value of the quotient of the product of the factors by which the sampling frequency is stepped up and the product of the factors by which the sampling frequency is stepped down for each further sampling frequency ($f_B$, $f_C$, $f_D$) corresponds to the value of the quotient of the further sampling frequency ($f_B$, $f_C$, $f_D$) and of the first sampling frequency ($f_A$).

7. Method according to one of the preceding claims, **characterized** **in that** the determination of the integer factors for each further sampling frequency ($f_B$, $f_C$, $f_D$) comprises the factorization of the numerator and/or of the denominator of a fraction which has the value of the quotient of the further sampling frequency ($f_B$, $f_C$, $f_D$) and of the first sampling frequency ($f_A$).

8. Method according to one of the preceding claims, **characterized** **in that** the fraction is a shortened fraction composed of natural numbers.

9. Method according to one of the preceding claims, **characterized** **in that** one or more of the further sampling frequencies ($f_B$, $f_C$, $f_D$) corresponds to a sampling frequency provided for a mobile radio standard, or to an integer multiple of it.

10. Method according to one of the preceding claims, **characterized** **in that** one sampling frequency ($f_B$) from the further sampling frequencies ($f_B$, $f_C$, $f_D$) is the sampling frequency provided from the UMTS Standard, or is an integer multiple of it, and/or **in that** one sampling frequency ($f_C$) of the further sampling frequencies ($f_B$, $f_C$, $f_D$) is the sampling frequency provided for the DECT Standard, or is an integer multiple of it, and/or in that one sampling frequency ($f_D$) of the further sampling frequencies ($f_B$, $f_C$, $f_D$) is the sampling frequency provided for the GSM Standard, or is an integer multiple of it.

11. Method according to one of the preceding claims, **characterized** **in that** the first sampling frequency ($f_A$) is 16384 kHz, and/or in that the first sampling frequency ($f_A$) is the sampling frequency of an analogue/digital converter.

12. Method according to one of the preceding claims, **characterized** **in that** the first sampling frequency ($f_A$) is stepped down by the factors 2 and 2 in order to produce the sampling frequency for the UMTS Standard.

13. Method according to one of the preceding claims, **characterized** **in that** the first sampling frequency ($f_A$) is stepped down by the factors 2, 8 and 8 and is stepped up by the factors 3 and 3 in order to produce the sampling frequency for the DECT Standard.

14. Method according to one of the preceding claims, **characterized** **in that** the first sampling frequency ($f_A$) is stepped down by the factors 2, 8, 12, 8, 8 and 8 and is stepped up by the factors 13, 5, 5 and 5 in order to produce the sampling frequency for the GSM Standard.

15. Apparatus for conversion of a first sampling frequency ($f_A$) of a digital signal, which is produced by an analogue/digital conversion, which is carried out at the first sampling frequency ($f_A$), of a signal which is received by the apparatus, to two or more further sampling frequencies ($f_B$, $f_C$, $f_D$), with the apparatus having means for carrying out at least two partial conversion steps for each further sampling frequency ($f_B$, $f_C$, $f_D$), with each partial conversion step comprising the stepping up or the stepping down of the sampling frequency by a factor, and at least one result of a partial conversion step being used to produce at least two different further sampling frequencies ($f_B$, $f_C$, $f_D$), **characterized** **in that** the analogue signal represents a bit stream of a mobile radio signal at a bit rate, and **in that** at least one of the further sampling frequencies ($f_B$, $f_C$, $f_D$) is an integer multiple of the bit rate.

16. Apparatus according to Claim 15, **characterized** **in that** the means are formed by one or more suitable polyphase filters.

17. Apparatus according to one of Claims 15 or 16, **characterized** **in that** the first sampling frequency ($f_A$) is greater than the further sampling frequencies ($f_B$, $f_C$, $f_D$).

18. Apparatus according to one of Claims 15 to 17, **characterized** **in that** the analogue signal is a received mobile radio signal which corresponds to the UMTS, DECT or GSM Standard.

19. Apparatus according to one of Claims 15 to 18, **characterized** **in that** each factor is an integer factor.

20. Apparatus according to one of Claims 15 to 19, **characterized** **in that** the value of the quotient of the product of the factors by which the sampling frequency is stepped up and the product of the factors by which the sampling frequency is stepped down for each further sampling frequency ($f_B$, $f_C$, $f_D$) corresponds to the value of the quotient of the further sampling frequency ($f_B$, $f_C$, $f_D$) and of the first sampling frequency ($f_A$).

21. Apparatus according to one of Claims 15 to 20, **characterized** **in that** the determination of the integer factors for each sampling frequency ($f_B$, $f_C$, $f_D$) comprises the factorization of the numerator and/or of the denominator of a fraction which has the value of the quotient of the further sampling frequency ($f_B$, $f_C$, $f_D$) and of the first sampling frequency ($f_A$).

22. Apparatus according to one of Claims 15 to 21, **characterized** **in that** the fraction is a shortened fraction composed of natural numbers.

23. Apparatus according to one of Claims 15 to 22, **characterized** **in that** one or more of the further sampling frequencies ($f_B$, $f_C$, $f_D$) corresponds to a sampling frequency provided for a mobile radio standard, or to an integer multiple of it.

24. Apparatus according to one of Claims 15 to 23, **characterized** **in that** one sampling frequency ($f_B$) from the further sampling frequencies ($f_B$, $f_C$, $f_D$) is the sampling frequency provided for the UMTS Standard, or is an integral multiple of it, and/or in that one sampling frequency ($f_C$) of the further sampling frequencies ($f_B$, $f_C$, $f_D$) is the sampling frequency provided for the DECT Standard, or is an integer multiple of it, and/or in that one sampling frequency ($f_D$) of the further sampling frequencies ($f_B$, $f_C$, $f_D$) is the sampling frequency provided for the GSM Standard, or is an integer multiple of it.

25. Apparatus according to one of Claims 15 to 24, **characterized** **in that** the first sampling frequency ($f_A$) is 16384 kHz, and/or in that the first sampling frequency ($f_A$) is the sampling frequency of an analogue/digital converter.

26. Apparatus according to one of Claims 15 to 25, **characterized in that** the first sampling frequency ($f_A$) is stepped down by the factors 2 and 2 in order to produce the sampling frequency for the UMTS Standard.

27. Apparatus according to one of Claims 15 to 26, **characterized in that** the first sampling frequency ($f_A$) is stepped down by the factors 2, 8 and 8 and is stepped up by the factors 3 and 3 in order to produce the sampling frequency for the DECT Standard.

28. Apparatus according to one of Claims 15 to 27, **characterized in that** the first sampling frequency ($f_A$) is stepped down by the factors 2, 8, 12, 8, 8 and 8 and is stepped up by the factors 13, 5, 5 and 5 in order to produce the sampling frequency for the GSM Standard.

29. Apparatus according to one of Claims 15 to 28, **characterized in that** the apparatus is a mobile radio terminal.

## Revendications

1. Procédé de conversion d'une première fréquence d'échantillonnage ($f_A$) d'un signal numérique, qui est produit par une conversion analogique-numérique, effectuée avec la première fréquence d'échantillonnage ($f_A$), d'un signal analogique, en plusieurs autres fréquences d'échantillonnage ($f_B$, $f_C$, $f_D$), dans lequel la conversion respective est divisée en au moins deux étapes de conversion partielle dont chacune comprend l'augmentation ou la diminution de la fréquence d'échantillonnage d'un facteur, au moins un résultat d'une étape de conversion partielle étant utilisé pour produire au moins deux autres fréquences d'échantillonnage différentes ($f_B$, $f_C$, $f_D$), **caractérisé par le fait que** le signal analogique représente un flux de bits d'un signal de radiocommunication mobile avec un débit binaire et qu'au moins l'une des autres fréquences d'échantillonnage ($f_B$, $f_C$, $f_D$) est un multiple entier du débit binaire.

2. Procédé selon l'une des revendications précédentes, **caractérisé par le fait que** la première fréquence d'échantillonnage ($f_A$) est supérieure aux autres fréquences d'échantillonnage ($f_B$, $f_C$, $f_D$).

3. Procédé selon l'une des revendications précédentes, **caractérisé par le fait que** le signal analogique est un signal reçu de radiocommunication mobile.

4. Procédé selon l'une des revendications précédentes, **caractérisé par le fait que** le signal analogique est un signal reçu de radiocommunication mobile qui correspond au standard UMTS, DECT ou GSM.

5. Procédé selon l'une des revendications précédentes, **caractérisé par le fait que** chaque facteur est un facteur entier.

6. Procédé selon l'une des revendications précédentes, **caractérisé par le fait que** la valeur du quotient entre le produit des facteurs, desquels la fréquence d'échantillonnage est augmentée, et le produit des facteurs, desquels la fréquence d'échantillonnage est diminuée, correspond pour chaque autre fréquence d'échantillonnage ($f_B$, $f_C$, $f_D$) à la valeur du quotient entre l'autre fréquence d'échantillonnage ($f_B$, $f_C$, $f_D$) et la première fréquence d'échantillonnage ($f_A$).

7. Procédé selon l'une des revendications précédentes, **caractérisé par le fait que** la détermination des facteurs entiers pour chaque autre fréquence d'échantillonnage ($f_B$, $f_C$, $f_D$) comprend la factorisation du numérateur et/ou du dénominateur d'une fraction qui a la valeur du quotient entre l'autre fréquence d'échantillonnage ($f_B$, $f_C$, $f_D$) et la première fréquence d'échantillonnage ($f_A$).

8. Procédé selon l'une des revendications précédentes, **caractérisé par le fait que** la fraction est une fraction tronquée de nombres naturels.

9. Procédé selon l'une des revendications précédentes, **caractérisé par le fait qu'**une ou plusieurs des autres fréquences d'échantillonnage ($f_B$, $f_C$, $f_D$) correspondent à une fréquence d'échantillonnage prévue dans un standard de radiocommunication mobile ou à un multiple entier de celle-ci.

10. Procédé selon l'une des revendications précédentes, **caractérisé par le fait qu'**une fréquence d'échantillonnage ($f_B$) parmi les autres fréquences d'échantillonnage ($f_B$, $f_C$, $f_D$) est la fréquence d'échantillonnage prévue dans le standard UMTS ou un multiple entier de celle-ci et/ou qu'une fréquence d'échantillonnage ($f_C$) parmi les autres fréquences d'échantillonnage ($f_B$, $f_C$, $f_D$) est la fréquence d'échantillonnage prévue dans le standard DECT ou un multiple entier de celle-ci et/ou qu'une fréquence d'échantillonnage ($f_D$) parmi les autres fréquences d'échantillonnage ($f_B$, $f_C$, $f_D$) est la fréquence d'échantillonnage prévue dans le standard GSM ou un multiple entier de celle-ci.

11. Procédé selon l'une des revendications précédentes,
    **caractérisé par le fait que** la première fréquence d'échantillonnage ($f_A$) vaut 16 384 kHz et/ou que la première fréquence d'échantillonnage ($f_A$) est la fréquence d'échantillonnage d'un convertisseur analogique-numérique.

12. Procédé selon l'une des revendications précédentes,
    **caractérisé par le fait que** la première fréquence d'échantillonnage ($f_A$) est diminuée des facteurs 2 et 2 pour produire la fréquence d'échantillonnage du standard UMTS.

13. Procédé selon l'une des revendications précédentes,
    **caractérisé par le fait que** la première fréquence d'échantillonnage ($f_A$) est diminuée des facteurs 2, 8 et 8 et augmentée des facteurs 3 et 3 pour produire la fréquence d'échantillonnage du standard DECT.

14. Procédé selon l'une des revendications précédentes,
    **caractérisé par le fait que** la première fréquence d'échantillonnage ($f_A$) est diminuée des facteurs 2, 8, 12, 8, 8 et 8 et augmentée des facteurs 13, 5, 5 et 5 pour produire la fréquence d'échantillonnage du standard GSM.

15. Dispositif de conversion d'une première fréquence d'échantillonnage ($f_A$) d'un signal numérique, qui est produit par une conversion analogique-numérique, effectuée avec la première fréquence d'échantillonnage ($f_A$), d'un signal reçu par le dispositif, en plusieurs autres fréquences d'échantillonnage ($f_B$, $f_C$, $f_D$), le dispositif comportant des moyens pour mettre en oeuvre au moins deux étapes de conversion partielle par autre fréquence d'échantillonnage ($f_B$, $f_C$, $f_D$), chaque étape de conversion partielle comprenant l'augmentation ou la diminution de la fréquence d'échantillonnage d'un facteur et au moins un résultat d'une étape de conversion partielle étant utilisé pour produire au moins deux autres fréquences d'échantillonnage différentes ($f_B$, $f_C$, $f_D$),
    **caractérisé par le fait que** le signal analogique représente un flux de bits d'un signal de radiocommunication mobile avec un débit binaire et qu'au moins l'une des autres fréquences d'échantillonnage ($f_B$, $f_C$, $f_D$) est un multiple entier du débit binaire.

16. Dispositif selon la revendication 15,
    **caractérisé par le fait que** les moyens sont formés par un ou plusieurs filtres polyphasés appropriés.

17. Dispositif selon l'une des revendications 15 à 16,
    **caractérisé par le fait que** la première fréquence d'échantillonnage ($f_A$) est supérieure aux autres fréquences d'échantillonnage ($f_B$, $f_C$, $f_D$).

18. Dispositif selon l'une des revendications 15 à 17,
    **caractérisé par le fait que** le signal analogique est un signal reçu de radiocommunication mobile qui correspond au standard UMTS, DECT ou GSM.

19. Dispositif selon l'une des revendications 15 à 18,
    **caractérisé par le fait que** chaque facteur est un nombre entier.

20. Dispositif selon l'une des revendications 15 à 19,
    **caractérisé par le fait que** la valeur du quotient entre le produit des facteurs, desquels la fréquence d'échantillonnage est augmentée, et le produit des facteurs, desquels la fréquence d'échantillonnage est diminuée, correspond pour chaque autre fréquence d'échantillonnage ($f_B$, $f_C$, $f_D$) à la valeur du quotient entre l'autre fréquence d'échantillonnage ($f_B$, $f_C$, $f_D$) et la première fréquence d'échantillonnage ($f_A$).

21. Dispositif selon l'une des revendications 15 à 20,
    **caractérisé par le fait que** la détermination des facteurs entiers pour chaque autre fréquence d'échantillonnage ($f_B$, $f_C$, $f_D$) comprend la factorisation du numérateur et/ou du dénominateur d'une fraction qui a la valeur du quotient entre l'autre fréquence d'échantillonnage ($f_B$, $f_C$, $f_D$) et la première fréquence d'échantillonnage ($f_A$).

22. Dispositif selon l'une des revendications 15 à 21,
    **caractérisé par le fait que** la fraction est une fraction tronquée de nombres naturels.

23. Dispositif selon l'une des revendications 15 à 22,
    **caractérisé par le fait qu'**une ou plusieurs des autres fréquences d'échantillonnage ($f_B$, $f_C$, $f_D$) correspondent à une fréquence d'échantillonnage prévue dans un standard de radiocommunication mobile ou à un multiple entier de celle-ci.

24. Dispositif selon l'une des revendications 15 à 23,

**caractérisé par le fait qu'**une fréquence d'échantillonnage ($f_B$) parmi les autres fréquences d'échantillonnage ($f_B$, $f_C$, $f_D$) est la fréquence d'échantillonnage prévue dans le standard UMTS ou un multiple entier de celle-ci et/ou qu'une fréquence d'échantillonnage ($f_C$) parmi les autres fréquences d'échantillonnage ($f_B$, $f_C$, $f_D$) est la fréquence d'échantillonnage prévue dans le standard DECT ou un multiple entier de celle-ci et/ou qu'une fréquence d'échantillonnage ($f_D$) parmi les autres fréquences d'échantillonnage ($f_B$, $f_C$, $f_D$) est la fréquence d'échantillonnage prévue dans le standard GSM ou un multiple entier de celle-ci.

25. Dispositif selon l'une des revendications 15 à 24, **caractérisé par le fait que** la première fréquence d'échantillonnage ($f_A$) vaut 16 384 kHz et/ou que la première fréquence d'échantillonnage ($f_A$) est la fréquence d'échantillonnage d'un convertisseur analogique-numérique.

26. Dispositif selon l'une des revendications 15 à 25, **caractérisé par le fait que** la première fréquence d'échantillonnage ($f_A$) est diminuée des facteurs 2 et 2 pour produire la fréquence d'échantillonnage du standard UMTS.

27. Dispositif selon l'une des revendications 15 à 26, **caractérisé par le fait que** la première fréquence d'échantillonnage ($f_A$) est diminuée des facteurs 2, 8 et 8 et augmentée des facteurs 3 et 3 pour produire la fréquence d'échantillonnage du standard DECT.

28. Dispositif selon l'une des revendications 15 à 27, **caractérisé par le fait que** la première fréquence d'échantillonnage ($f_A$) est diminuée des facteurs 2, 8, 12, 8, 8 et 8 et augmentée des facteurs 13, 5, 5 et 5 pour produire la fréquence d'échantillonnage du standard GSM.

29. Dispositif selon l'une des revendications 15 à 28, **caractérisé par le fait que** c'est un terminal de radiocommunication mobile.

**FIG.**

Re
Im

$f_A = 16384$ kHz

| 10 AD |

| 1 | ↓ 2 |

⊗

| 2 | ↓ 2 | → UMTS
$f_B = 4096$ kHz

| ↑ 3 | 3 | ↓ 8 | | ↑ 3 | 4 | ↓ 8 | → DECT
$f_C = 1152$ kHz

| 5 | ↓ 8 | | ↑ 13 | 6 | ↓ 12 | | ↑ 5 | 7 | ↓ 8 |

| ↑ 5 | 8 | ↓ 8 | | ↑ 5 | 9 | ↓ 8 | → GSM
$f_b = 270{,}83$ kHz

EP 1 316 147 B1